(19) Europäisches Patentamt / European Patent Office / Office européen des brevets

(11) **EP 4 379 399 B1**

(12) **EUROPEAN PATENT SPECIFICATION**

(45) Date of publication and mention of the grant of the patent:
**22.07.2026 Bulletin 2026/30**

(21) Application number: **22210653.6**

(22) Date of filing: **30.11.2022**

(51) International Patent Classification (IPC):
*G01R 27/08* (2006.01)   *G01R 27/26* (2006.01)
*G01R 31/26* (2020.01)   *G01R 31/27* (2006.01)
*G01R 31/28* (2006.01)   *G01R 31/64* (2020.01)

(52) Cooperative Patent Classification (CPC):
**G01R 31/27; G01R 27/08; G01R 27/2605;
G01R 31/2642; G01R 31/2813; G01R 31/2817;
G01R 31/64;** G01R 31/2621

(54) **PARAMETER ESTIMATION FOR VOLTAGE MEASUREMENTS IN NOISY ENVIRONMENTS**

PARAMETERSCHÄTZUNG FÜR SPANNUNGSMESSUNGEN IN UMGEBUNGEN MIT HOHEM RAUSCHPEGEL

ESTIMATION DE PARAMÈTRES POUR DES MESURES DE TENSION DANS DES ENVIRONNEMENTS BRUYANTS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**05.06.2024 Bulletin 2024/23**

(73) Proprietor: **Hitachi Energy Ltd 8050 Zürich (CH)**

(72) Inventor: **Asoodar, Mohsen 164 56 Kista (SE)**

(74) Representative: **AWA Sweden AB Box 45086 104 30 Stockholm (SE)**

(56) References cited:
WO-A1-2013/107497   WO-A1-2017/071754
US-A1- 2017 254 842

## Description

### Technical field

The present disclosure relates generally to the field of electrical power systems. More specifically it relates to a method for parameter estimation in an electrical power system.

### Background

Measurements are inevitably inaccurate. This is partly due to the measurement accuracy, but also due to noise. Measurement inaccuracies such as offsets can be corrected by comparing to a reference, however inaccuracies such as noise cannot be simply mitigated. One solution is to reduce noise at the cost of lowering the bandwidth (analog or digital), however, this would skew the measurements at the frequency of interest, manipulate their magnitude and complicate high frequency measurements. For linear time-invariant (LTI) systems, Kalman filtering and other recursive estimation algorithms have shown to be effective in reducing the effect of noise. However, such algorithms are only effective when a reasonable amount of noise is present. What counts as reasonable depends on the application and the required accuracies, but for condition monitoring of components where +99% accuracy is needed, even 3% noise in voltage and current measurements has shown to be too much.

US 2017/254842 A1 discloses systems to determine an on-state impedance of a high voltage transistor. WO 2017/071754 A1 discloses a processing module for use in conjunction with at least one capacitor included in a converter.

### Summary

It is therefore an object of the present invention to overcome at least some of the above-mentioned drawbacks, and to provide an estimation of parameters based on noisy measurements, in particular voltage and/or current measurements.

According to the invention, this and other objects are achieved by means of the subject-matter as defined in the appended independent claims. Other embodiments are defined by the dependent claims.

According to a first aspect of the present invention, a method for estimating an ON-state resistance of a semiconductor switch in an electric power converter is provided. The method comprises obtaining an ON-state voltage of the semiconductor switch from a measurement circuit. The method further comprises obtaining an ON-state current through the semiconductor switch. The method further comprises integrating the ON-state voltage over a period of time to obtain an integrated voltage. The method further comprises integrating the ON-state current over the same period of time to obtain an integrated current. The method further comprises determining an ON-state resistance estimate of the semiconductor switch based on the integrated voltage and the integrated current.

A converter may comprise a plurality of submodules connected in series, e.g. in one or more arms, such that if an arm of the converter has N submodules, the converter output voltage will have N+1 or 2N+1 levels (e.g. depending on whether submodules comprise half- or full-bridges, respectively), where each level is a voltage contribution for each step of the step-wise built output waveform for the converter (i.e. N levels of VSM plus zero, where VSM is a voltage contribution from a single submodule). Thus, typically, the more levels a converter has, the more a step-wise-built output waveform may approximate an AC waveform, for example.

Submodules of such converters may typically comprise capacitors connected to modulated switches, these electronic components being arranged in e.g. a half-bridge or full-bridge configuration. The switches may be modulated (e.g. by a converter control unit) in such a way as to switch the capacitors into and out of a contribution to a voltage output of the converter so as to build an output waveform in a stepwise fashion. The modulation scheme may be configured such that the output waveform approximates an AC waveform.

The ON-state is when the semiconductor switch is closed, i.e. ON. Therefore, the ON-state voltage is the voltage across the semiconductor switch when the semiconductor switch is closed. The ON-state current is the current through the semiconductor switch when the semiconductor switch is closed.

The ON-state voltage may be measured across the semiconductor switch. In a converter, the ON-state voltage measurement often has a small signal value (in the 0-4 V range) and is naturally in a noisy environment, the signal to noise ratio (SNR) may therefore be low. Depending on the design of the system, the noise could be at the same level as, or even higher than. the signal. The SNR may therefore be as low as a few percent (e.g. 5%), or as high as above 90%.

Further, the operating point of the converter may also affect the SNR. If the sensors are designed to capture nominal voltage and current levels, a decrease in load to, e.g., 10% of nominal current may lead to a decrease in the SNR, which is not because the noise grew, but because the signal is reduced.

For lower SNR values, it is difficult to extract a reliable signal value using conventional methods.

The ON-state current of the semiconductor switch may be measured at the switch. Alternatively, if the semiconductor switch is arranged in a submodule of the converter, the ON-state current may be estimated based on a measured current through the submodule and an obtained switching function of the switch. For example, the ON-state current may be estimated as:

$$i_{ON}(t) = i_{arm}(t) \times s(t) = \hat{\imath} \sin(\omega t + \varphi_i) \times s(t)$$

Where $\hat{\imath} \sin(\omega t + \varphi_i)$ is the current through the submodule, and $s(t)$ is the switching pattern/function of the switch.

For example, the current through the submodule may be an arm or chain-link current in a multi-level modular converter, MMC. For a 2- or 3-level converter, an output current or load current may be measured and used for estimating the ON-state current.

In converters, the current through the submodule (e.g., arm current or load current) is often measured for other purposes. Therefore, this estimation may be made without additional sensors.

By integrating the voltage and the current, the signal values may increase over time, while the noise levels may not increase at the same rate. The proposed method may therefore increase the SNR artificially.

The period of time over which the signals are integrated may be in the range of 0.02-10 s. The longer the period of time, the more accurate the measurement may be. The integration time may be dependent on the switching frequency of the switch. For a higher switching frequency, a shorter period of time may be used, and for a lower switching frequency, a longer period of time may be used.

ON-state voltage may be a suitable parameter for condition monitoring of semiconductor devices (switches). A change in the ON-state voltage may typically be attributed to variation in the ON-state resistance. Hence, for condition monitoring, the ON-state resistance of the device/switch may be extracted. Since this resistance value is often quite small (in the mΩ range) accurate monitoring techniques are required.

With the present method, the resistance may be estimated based on measurements with improved SNR, which may provide a more reliable, and less noisy, estimate.

The resistance estimate may for example be estimated by dividing the integrated voltage with the integrated current.

The present method may provide a special parameter estimation technique in noisy environments. For example, the method may increase the accuracy of the resistance estimation, by minimizing the effect of the noise. The proposed method may be less sensitive to noise than traditional estimation methods, such as RLS (recursive least square) or Kalman filter.

According to the invention, the method further comprises obtaining a selected frequency. The method further comprises extracting voltage harmonics (or voltage harmonic components) of the selected frequency from the ON-state voltage. The method further comprises extracting current harmonics (or current harmonic components) of the selected frequency from the ON-state current. The integrating the ON-state voltage comprises integrating the voltage harmonics over the period of time to obtain the integrated voltage. The integrating the ON-state current comprises integrating the current harmonics over the period of time to obtain the integrated current.

In the proposed methods, integrated components of certain frequencies are used to increase the signal to noise ratio (SNR) artificially. Integration without prior extraction of harmonics of a selected frequency corresponds to an integration of the direct current components of the voltage/current. However, many sensors are especially sensitive to offsets for DC measurements. For other frequencies, the sensors may provide only a little or no offset to the measurements. Therefore, extracting harmonics of a selected frequency prior to integration may further increase the accuracy of the resulting estimates.

The selected frequency may be any selected frequency. For example, the selected frequency may be the fundamental frequency (or any integer multiplied with the fundamental frequency) of a power grid to which the converter is connected. The fundamental frequency (or any multiple thereof) may be especially predictable/measurable.

According to some embodiments, the extracting voltage harmonics of the selected frequency may comprise multiplying the ON-state voltage with a vector rotating at the selected frequency. The extracting current harmonics of the selected frequency may comprise multiplying the ON-state current with a vector rotating at the selected frequency.

According to some embodiments, the method may further comprise obtaining a voltage offset of the obtained voltage. The method may further comprise obtaining a current offset of the obtained current. The method may further comprise adjusting the resistance estimate based on the voltage offset and the current offset.

As mentioned above, the sensors are often especially sensitive to offsets for DC values. Therefore, for DC estimates, the offset may be determined separately (e.g. using a self-correcting ADC) and removed from the voltage and/or current measurement prior to the estimation of the resistance.

According to some embodiments, a method for determining a state of health of a semiconductor switch in an electric power converter may be provided. **The** method may comprise determining an ON-state resistance estimate of the semiconductor switch in accordance with any of the above-described embodiments. **The** method may further comprise determining a state of health of the semiconductor switch based on the determined ON-state resistance estimate.

For example, the estimated resistance may be monitored over time, to detect changes in the resistance. **The** estimated resistance may be compared with an initial value of the resistance, to identify a change in the resistance. The estimated resistance may be compared with a threshold value, to detect when the resistance has reached a limit.

According to some embodiments, the converter may comprise a plurality of series-connected submodules. Each of the submodules may comprise a capacitor and a plurality of semiconductor switches arranged in a half-bridge or a full-bridge submodule topology. The semiconductor switch (mentioned in the method embodiments described above) may be one of the plurality of semiconductor switches of one of the series-connected submodules.

For example, the submodules may form part of a converter arm of a power converter.

According to some embodiments, the semiconductor switch may be one of a group of semiconductor switches arranged in a same position in the circuit topology of their respective submodule. The determining an ON-state resistance estimate may comprise determining an ON-state resistance estimate for each of the group of semiconductor switches. The determining a state of health may comprise determining, for the group of semiconductor switches, a group value of the estimated resistance. The determining a state of health may further comprise determining a deviation of the estimated resistance from the group value, for at least one semiconductor switch in the group. The determining a state of health may further comprise determining a state of health for the at least one semiconductor switch of the group based on the determined deviation for the semiconductor switch.

As used herein, the 'topology' of a circuit may be thought of as the relative electrical position of a component in a circuit, decoupled from any consideration of the physical position of said component. Thus, components having a same position in a same circuit topology may experience the same electrical behavior under the same electrical conditions.

The group value, which may be an average (e.g. mean, median) of the estimated resistance for each semiconductor switch in the group.

A 'group' is defined by as being a corresponding electrical component from each submodule, in the plurality of submodules, having a same position in the circuit topology of their respective submodule. For example, in submodules that all have a full-bridge submodule topology, the capacitor in each submodule will be arranged in a same position in the full-bridge submodule topology. Similarly, each of the plurality of semiconductor switches will have a position in the circuit topology such that switches in a same position in different submodules will experience a same electrical behavior (e.g. according to the modulation scheme for the converter).

Thus, as each electrical component in said group is experiencing the same electrical behavior, it can be assumed that the average power losses for each component in the group are the same, considering also that the plurality of submodules/electric storage units are connected in series such that current is evenly shared thereacross.

According to a second aspect of the present invention, a method for estimating a circuit parameter of a supercapacitor in an energy storage system is provided. The method comprises injecting a current in the super capacitor. The method further comprises obtaining, from a measurement circuit, a voltage measured across the supercapacitor. The method further comprises integrating the voltage over a period of time, to obtain an integrated voltage. The method further comprises integrating the injected current over the same period of time, to obtain an integrated current. The method further comprises determining a circuit parameter estimate of the supercapacitor based on the integrated voltage and the integrated current.

An energy storage system (ESS) may comprise a plurality of energy storage units (ESUs) connected in series, e.g., in one or more strings, wherein each ESU may comprise a battery management system (BMS), which may also be referred to as an energy storage management system (ESMS), configured to balance the amounts of stored electrical energy between ESUs in a string. The supercapacitor of the second aspect of the present disclosure may be an ESU of an energy storage system.

The circuit parameter may for example be a capacitance, an equivalent series resistance (ESR) or a leakage resistance.

For the supercapacitors, the integration time may be different from the integration period of the first aspect above. For the supercapacitors, the current is injected, meaning that the frequency of the current and the time of the injection may be controlled. The dynamics of supercapacitor systems may typically be slow. Therefore, a longer integration time may be used. For high frequencies, e.g., in the range 50-1000 Hz, or more, the integration period may be in the range of seconds. For low frequencies, e.g., in the range 1-50 Hz, or less, the integration period may be in the range of seconds, minutes, or in some case hours.

Further, the integration time may be related to a magnitude of the injected current. For example, for a larger magnitude of the injected current, the integration time may be shorter, and vice versa.

As for the semiconductor switch described above, the voltage across a supercapacitor may have a small signal value in a noisy environment. The SNR may thus be low for measurements of the supercapacitor voltage. The method of the second aspect therefore provides the same solution as the method in the first aspect, but for a different device. It will be appreciated that similar advantages and explanations as provided above for the method of the first aspect may apply to the method of the second aspect. For brevity, not all of the explanations and advantages will be repeated for the second aspect.

According to the invention, the injected current has a selected frequency. The method further comprises extracting voltage harmonics of the selected frequency from the voltage. The method further extracting current harmonics of the selected frequency from the injected current. The integrating the voltage comprises integrating the voltage harmonics over the period of time to obtain the integrated voltage. The integrating the current comprises integrating the current harmonics over the period of time to obtain the integrated current.

As discussed above, many sensors are sensitive to offsets for direct current measurements. At frequencies other than 0 Hz, the measurements may be less affected by offsets. Therefore, by extracting harmonic content of a selected frequency prior to integration, the integration may be based on more exact measurements, which may further increase the accuracy of the estimation.

According to some embodiments, the extracting voltage harmonics of the selected frequency may comprise multiplying the voltage with a vector rotating at the selected frequency. The extracting current harmonics of the selected frequency may comprise multiplying the injected current with a vector rotating at the selected frequency.

According to some embodiments, the method may further comprise obtaining a voltage offset of the obtained voltage. The method may further comprise obtaining a current offset of the obtained current. The method may further comprise adjusting the circuit parameter estimate based on the voltage offset and the current offset.

As described above for the first aspect of the present disclosure, many sensors are sensitive for direct current measurements. Such sensors often introduce measurement offsets for DC measurements. Integrating the measured signal values may correspond to an extraction and amplification of the direct current components of the signal. By obtaining (estimating, determining) the offsets of the measurements, and removing them prior to the estimation of the circuit parameter, the accuracy of the estimation may be further improved.

According to some embodiments, the method may further comprise obtaining current measurements of a current running through the supercapacitor. The integrating the injected current may comprise integrating the current measurements to obtain the integrated current.

The actual injected current, passing through the supercapacitor, may in some cases differ from the reference current, for example when using open loop current injection. Measuring the resulting (actual) current passing through the supercapacitor may therefore further improve the parameter estimation.

According to some embodiments, a method for determining a state of health of a supercapacitor in an energy storage system may be provided. The method may comprise determining a circuit parameter estimate of the supercapacitor in accordance with any of the above-described method embodiments of the second aspect. The method may further comprise determining a state of health of the supercapacitor based on the determined circuit parameter estimate.

As for the estimated resistance, described above, the estimated circuit parameter may be monitored over time, to detect changes in the resistance. The estimated circuit parameter may be compared with an initial value of the resistance, to identify a change in the resistance. The estimated circuit parameter may be compared with a threshold value, to detect when the resistance has reached a limit.

According to some embodiments, the supercapacitor may be one of a group of supercapacitors arranged in series.

For example, the plurality of supercapacitors may be a plurality of series-connected energy storage units (ESUs).

For example, the supercapacitor may be arranged as a DC link of a converter.

According to some embodiments, the determining a circuit parameter estimate may comprise determining a circuit parameter estimate for each of the group of supercapacitors arranged in series. The determining a state of health may comprise determining, for the group of supercapacitors a group value of the circuit parameter estimate. The determining a state of health may further comprise determining a deviation of the circuit parameter estimate from the group value, for at least one supercapacitor in the group. The determining a state of health may further comprise determining a state of health for the at least one supercapacitor of the group based on the determined deviation for the supercapacitor.

In a group of series-connected supercapacitors, each of the supercapacitors is subject to the same current. Thus, as each of the supercapacitors is experiencing the same electrical behavior, it can be assumed that the average power losses for each component in the group are the same, considering also that the plurality of ESUs are connected in series such that current is evenly shared thereacross.

During operation of an ESS, temperature-associated variations in electrical characteristics of the series-connected supercapacitors can be assumed to be substantially the same. A significant deviation of a component value for a circuit parameter from the group value can be attributed to poor health of the individual component having said deviating component value.

The methods of the first and second aspects of the present invention may be at least in part implemented in a control unit. According to another aspect of the present invention, a control unit comprises means for carrying out the method of any of the embodiments of the first aspect. According to a further aspect of the present invention, a control unit comprises means for carrying out the method of any of the embodiments of the second aspect.

A converter may comprise a control unit comprising means for carrying out the method of any of the embodiments of the first aspect. An energy storage system may comprise a control unit comprising means for carrying out the method of any of the embodiments of the second aspect.

A power station may comprise a converter comprising a control unit comprising means for carrying out the method of any of the embodiments of the first aspect. A power station may comprise an energy storage system comprising a control unit comprising means for carrying out the method of any of the embodiments of the second aspect.

The methods of the first and/or second aspects may be provided as computer readable instructions. For example, a non-transitory computer-readable medium may comprise instructions which, when executed by a computer, may cause the computer to carry out the method of any of the embodiments of the first and/or second aspects.

## Brief description of drawings

Exemplifying embodiments will now be described in more detail, with reference to the following appended drawings:

Figure 1 schematically shows measurement circuit for a semiconductor switch;
Figure 2 schematically shows an example converter coupled to an AC power grid, the converter having a plurality of series-connected submodules;
Figure 3 schematically shows an example circuit topology for a submodule of a converter;
Figure 4 is a flowchart illustrating a method for estimating an ON-state resistance of a semiconductor switch in an electric power converter, in accordance with some embodiments;
Figure 5 is a flowchart illustrating a method for estimating a circuit parameter of a supercapacitor in an energy storage system, in accordance with some embodiments;
Figure 6 schematically shows a supercapacitor; and
Figure 7 schematically shows a group of supercapacitors arranged in series.

As illustrated in the figures, the sizes of the elements and regions may be exaggerated for illustrative purposes and, thus, are provided to illustrate the general structures of the embodiments. Like reference numerals refer to like elements throughout.

## Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness.

The proposed solution may be suitable for LTI systems, or nonlinear systems that may be modelled linearly for certain operation points. In a stable LTI system, the relation between two state variables (or between the input and the output) may be represented in the Laplace domain as,

$$\frac{Y(s)}{X(s)} = H(s) = \frac{a_0 + a_1 s + \cdots + a_n s^n}{b_0 + b_1 s + \cdots + b_n s^n}$$

$$(1)$$

In the time domain solution of (1) for a stable system, the real components decay as time becomes infinitely large, leaving only the oscillatory (imaginary) components. Hence, in steady-state, for every angular frequency $\omega$, $H(s)$ may be replaced by $H(j\omega)$ as,

$$\frac{Y(j\omega)}{X(j\omega)} = H(j\omega) = \frac{a_0 + a_1(j\omega) + \cdots + a_n(j\omega)^n}{b_0 + b_1(j\omega) + \cdots + b_n(j\omega)^n}$$

$$(2)$$

In other words, the linear relation between $X(j\omega)$ and $Y(j\omega)$ may be identified by extracting the $\omega^{th}$ harmonic content from $Y(j\omega)$ and $X(j\omega)$, and then dividing the extracted $\omega^{th}$ harmonic contents of $Y(j\omega)$ and $X(j\omega)$.

This solution may be accurate for a very large data set, during which $X(j\omega)$ and $Y(j\omega)$ are in steady state. For such a solution a fast Fourier transform (FFT) may be used to derive the relations between $X(j\omega)$ and $Y(j\omega)$.

However, if $X(j\omega)$ and $Y(j\omega)$ include noise, uncertainties, and/or change over time, the estimated value may differ depending on the window of data, the amount of noise, the load jumps, etc. Although this difference may be small, in certain applications, such as monitoring conditions, even 1% error in estimation is significant.

The present solution proposes a method for estimating $\dfrac{Y(j\omega)}{X(j\omega)}$, based on the corresponding signals in the time domain $y(t)$ and $x(t)$. Harmonics of a selected frequency of each of the time domain signals are extracted and integrated. The present solution provides that division of the extracted and integrated harmonics may provide an estimate for $\dfrac{Y(j\omega)}{X(j\omega)}$.

The methods according to the present disclosure, may artificially increase the value of the actual signal, while any frequency component that is not of the $\omega^{th}$ will not grow but remain in its oscillating state. For a long enough integration time, the effect of other harmonics on the integrated value of the $\omega^{th}$ frequency component may be negligible.

Mathematically, a proposal of the present disclosure is that,

$$\frac{\int y(t) \times e^{-j\omega t} dt}{\int x(t) \times e^{-j\omega t} dt} = \widehat{H}(j\omega),$$

$$(3)$$

may be a good estimate of $H(j\omega)$.

Different ways of extracting the phasor values $X(j\omega)$ and $Y(j\omega)$ exist. One proposal is to multiply the signal with a rotating vector with arbitrary initial phase, such that,

$$x_d = x(t) \times \cos(\omega t)$$

$$x_q = x(t) \times \sin(\omega t)$$

$$(4)$$

Due to the single-phase nature of $x_d$ and $x_q$, component and a component at $2\omega t$. As explained earlier, any non-dc component in (4) is not a concern when applying the proposed technique. Similar equations can be written for y(t) as well, to give,

$$y_d = y(t) \times \cos(\omega t)$$

$$y_q = y(t) \times \sin(\omega t)$$

$$(5)$$

$x(t)$ and $y(t)$ can be expanded as follows,

$$x(t) = x_{dc} + a_{x,\omega} \sin(\omega t + \varphi_{x,\omega}) + h_x$$

$$y(t) = y_{dc} + a_{y,\omega} \sin(\omega t + \varphi_{y,\omega}) + h_y$$

$$(6)$$

where $h_x$ and $h_y$ represent the harmonic content of $x(t)$ and $y(t)$ respectively.

Substituting of (4) with $x(t)$ of (6) yields,

$$x_d = \left(x_{dc} + a_{x,\omega} \sin\left(\omega t + \varphi_{x,\omega}\right) + h_x\right) \times \cos(\omega t) =$$

$$\frac{a_{x,\omega}}{2} \sin\left(\varphi_{x,\omega}\right) + \left(x_{dc} \times \cos(\omega t) + \frac{a_{x,\omega}}{2} \sin\left(2\omega t + \varphi_{x,\omega}\right) + h_x \times \cos(\omega t)\right)$$

$$x_q = \left(x_{dc} + a_{x,\omega} \sin\left(\omega t + \varphi_{x,\omega}\right) + h_x\right) \times \sin(\omega t) =$$

$$\frac{a_{x,\omega}}{2} \cos\left(\varphi_{x,\omega}\right) + \left(x_{dc} \times \sin(\omega t) + \frac{a_{x,\omega}}{2} \cos\left(2\omega t + \varphi_{x,\omega}\right) + h_x \times \sin(\omega t)\right)$$

$$( 7 )$$

As per definition, $h_x \times \cos(\omega t)$ and $h_x \times \sin(\omega t)$ contain no dc components. Hence, the only dc component of (7) are $\frac{a_{x,\omega}}{2} \sin\left(\varphi_{x,\omega}\right)$ for $x_d$ and $\frac{a_{x,\omega}}{2} \cos\left(\varphi_{x,\omega}\right)$ for $x_q$.

$$x_{d,IntT}(t) = \int_{t=0}^{t=T} x_d(t) = \int_{t=0}^{t=T} x(t) \times \cos(\omega t) =$$

$$T \frac{a_{x,\omega}}{2} \sin\left(\varphi_{x,\omega}\right) + \int_{t=0}^{t=T} \left(x_{dc} \times \cos(\omega t) + \frac{a_{x,\omega}}{2} \sin\left(2\omega t + \varphi_{x,\omega}\right) + h_x \times \cos(\omega t)\right)$$

$$x_{q,IntT}(t) = \int_{t=0}^{t=T} x_q(t) = \int_{t=0}^{t=T} x(t) \times \sin(\omega t) =$$

$$T \frac{a_{x,\omega}}{2} \cos\left(\varphi_{x,\omega}\right) + \int_{t=0}^{t=T} \left(x_{dc} \times \sin(\omega t) + \frac{a_{x,\omega}}{2} \cos\left(2\omega t + \varphi_{x,\omega}\right) + h_x \times \sin(\omega t)\right)$$

$$( 8 )$$

Both $x_{d,IntT}(t)$ and $x_{q,IntT}(t)$ comprise a dc term and an oscillatory term. The dc term of $x_{d,IntT}(t)$ and $x_{q,IntT}(t)$ grows over time as a result of the integration while the oscillatory terms remain oscillatory. Hence, for a large duration of integration, the oscillatory terms $x_{d,IntT}(t)$ and $x_{q,IntT}(t)$ become negligible compared to the integrated dc terms of the same.

That is,

$$\lim_{T\to\infty} x_{d,IntT}(t) = T \frac{a_{x,\omega}}{2} \sin\left(\varphi_{x,\omega}\right)$$

$$\lim_{T\to\infty} x_{q,IntT}(t) = T \frac{a_{x,\omega}}{2} \cos\left(\varphi_{x,\omega}\right)$$

$$( 9 )$$

Consequently, the vector magnitude of $X_{int}(j\omega)$ can be represented as

$$\lim_{T\to\infty} |X_{intT}(j\omega)|^2 = \left(\lim_{T\to\infty} x_{d,IntT}(t)\right)^2 + \left(\lim_{T\to\infty} x_{q,IntT}(t)\right)^2 \sim \left(T \frac{a_{x,\omega}}{2}\right)^2$$

$$( 10 )$$

Similarly, the vector magnitude of $Y_{int}(j\omega)$ can be represented as

$$\lim_{T\to\infty}|Y_{intT}(j\omega)|^2 = \left(\lim_{T\to\infty} y_{d,IntT}(t)\right)^2 + \left(\lim_{T\to\infty} y_{q,IntT}(t)\right)^2 \sim \left(T\frac{a_{y,\omega}}{2}\right)^2$$

(11)

Finally, $H_{int}(j\omega)$ becomes

$$\lim_{T\to\infty}|H_{intT}(j\omega)|^2 = \lim_{T\to\infty}\frac{|Y_{intT}(j\omega)|^2}{|X_{intT}(j\omega)|^2} = \frac{\left(T\frac{a_{y,\omega}}{2}\right)^2}{\left(T\frac{a_{x,\omega}}{2}\right)^2} = \left(\frac{a_{y,\omega}}{a_{x,\omega}}\right)^2 \sim \frac{|Y(j\omega)|^2}{|X(j\omega)|^2}$$

$$= |H(j\omega)|^2$$

(12)

In other words, $\lim_{T\to\infty}|H_{intT}(j\omega)|^2$ is used to estimate $|H(j\omega)|^2$ but with the advantage of artificially increasing the SNR of the measured $x(t)$ and $y(t)$ at the frequency $\omega$.

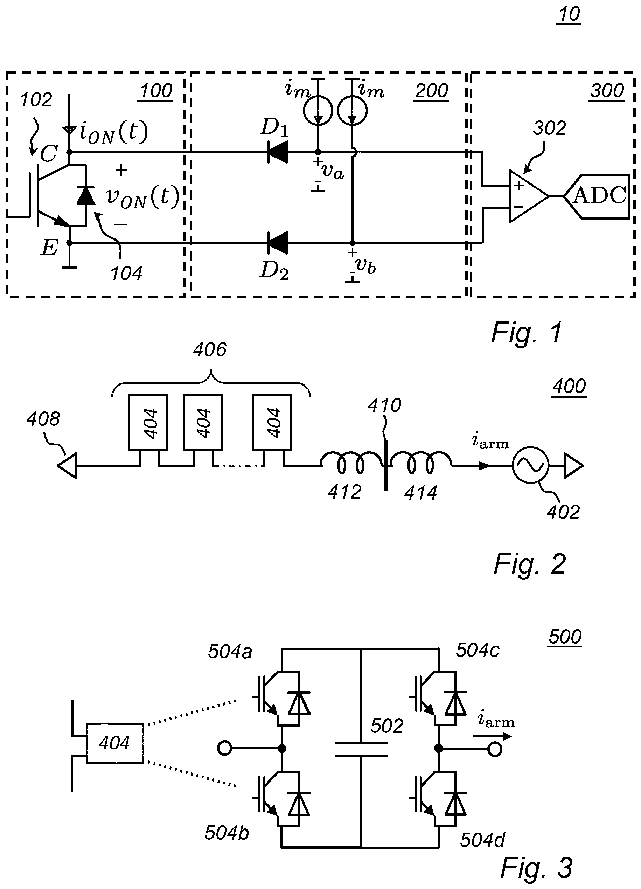

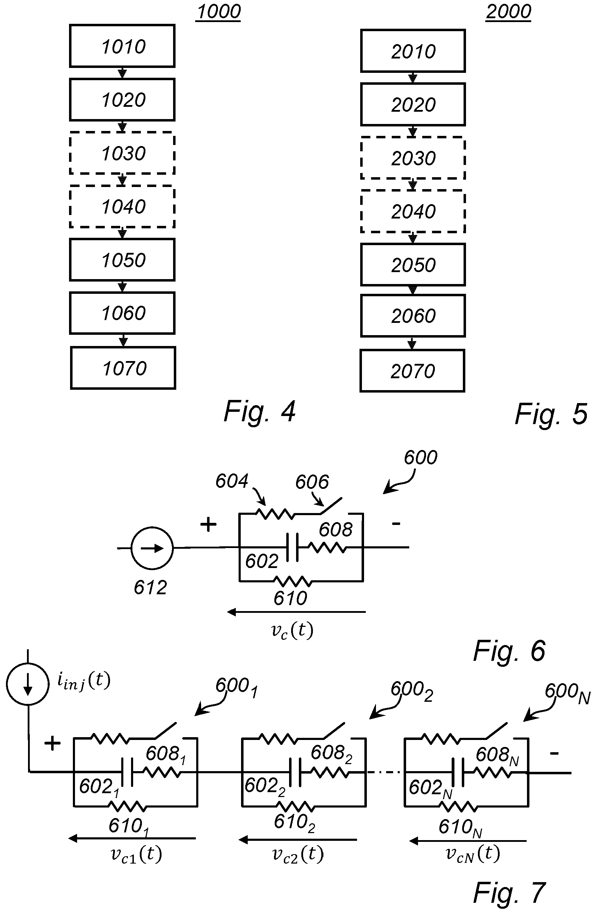

With reference to Figures 1 and 4, a method for estimating an ON-state resistance of a semiconductor switch in an electric power converter, in accordance with some embodiments, will be described.

Figure 1 is a circuit diagram illustrating a measurement circuit 10 for online measurement of ON-state voltage of a semiconductor device 100. The semiconductor device 100 may be referred to as a device under test (DUT 100). The measurement circuit 10 comprises the semiconductor device (switch) 100, including a transistor 102 and a diode 104. An ON-state current $i_{ON}(t)$ passes through the semiconductor switch 100, when in the ON-state. An ON-state voltage $v_{ON}(t)$ can be measured across the semiconductor switch 100, when in the ON-state, by the measurement circuit 10.

The measurement circuit 10 also includes a protection circuit 200. The protection circuit allows low voltages to pass through but blocks high voltages on the DUT. In the OFF-state, the voltage across the semiconductor switch 100 may be very high. The protection circuit 200 protects the sensors in the sensing circuit 300 from such high voltages.

In Figure 1, the sensing circuit 300 is an operational amplifier 302 and an analog-to-digital converter ADC for recording the measurements. In general, any differential or single ended measurement circuit, including any passive or active filtering circuit, may be used for the sensing circuit.

Figure 4 is a flowchart illustrating a method 1000 for estimating an ON-state resistance of a semiconductor switch in an electric power converter. The method 1000 may for example be used to estimate the ON-state resistance of the semiconductor switch 100 illustrated in Figure 1.

The method 1000 comprises obtaining, at step 1010, from a measurement circuit 10, an ON-state voltage $v_{ON}(t)$ of the semiconductor switch 100. At step 1020, an ON-state current $i_{ON}(t)$, through the semiconductor switch 100, is obtained. The method 1000 further comprises the optional steps 1030 and 1040. At the optional step 1030, voltage harmonics of an obtained selected frequency are extracted from the ON-state voltage $v_{ON}(t)$. At the optional step 1040, current harmonics of the obtained selected frequency are extracted from the ON-state current $i_{ON}(t)$.

Steps 1050 and 1060 are integration steps.

If the optional steps 1030 and 1040 are not present, the ON-state voltage $v_{ON}(t)$ is integrated over a period of time T at step 1050, the ON-state current $i_{ON}(t)$ is integrated over the period of time T at step 1060.

If the optional steps 1030 and 1040 are present, the extracted voltage harmonics are integrated over a period of time T at step 1050 and the extracted current harmonics are integrated over the period of time T at step 1060.

At step 1070, the resistance is estimated based on the results of the integrations from steps 1050 and 1060.

At step 1070, an obtained offset of the ON-state voltage measurement $v_{ON}(t)$ and/or the ON-state current measurement $i_{ON}(t)$ may be removed prior to the estimation of the resistance.

The estimated resistance may be used, in an optional further step (not depicted), to estimate a state of health of the semiconductor switch 100.

Figure 2 is an illustration of a converter 400 coupled to an AC power grid 402. The illustrated converter 400 has only one arm 406, which may also be referred to as a 'chain link', although it will be appreciated that the converter 10 may have more arms. Specifically, the converter 400 of Figure 2 is a single phase modular multilevel converter.

The converter 400 is grounded at grounding point 408 and is coupled to the AC power grid 402 via a point of common coupling 410, which may be a busbar or a similar component. The converter 400 may further comprise an inductor 412 or the converter 400 may have innate inductance that can be represented as an inductor 412. The inductance of the power grid 402 may be represented by an inductor 414.

A converter 10 such as that shown in Figure 2 may be controlled so as to convert electrical energy between DC and AC, for example. Thus, the converter may be a power converter suitable for HVDC applications. Examples sources of such DC electrical energy include solar panels, battery/capacitor banks (i.e. energy storage systems) and the like.

As illustrated in Figure 2, the converter 10 comprises a plurality of submodules 404 arranged in series.

Figure 3 schematically shows an example circuit topology 500 (or simply 'topology 500') for a submodule of a converter such as the submodules 404 of the converter 10 shown in Figure 2.

As illustrated in Figure 3, the circuit topology 500 of the submodule 404 may be a full-bridge submodule topology comprising a capacitor 502 and a plurality of semiconductor switches 504a, 504b, 504c, 504d (collectively 'semiconductor switches 504' or simply 'switches 1504'). The semiconductor switches 504 may be equivalent to the semiconductor switch 100 described above with reference to Figure 1. Specifically, the method 1000 described above with reference to Figure 4 may be applied to any one of the semiconductor switches 504.

According to this topology 100, current $i_{arm}$ may enter the circuit between the connections of switches 504a and 504b and exit the circuit between the connections of switches 504c and 504d. The current $i_{arm}$ may be a current flowing through the plurality of series-connected submodules 404, such that the same current ($i_{arm}$) may flow through all of the submodules 404 in the plurality of submodules (e.g., the arm 406 of the converter 10 shown in Figure 2).

The terminals of the capacitor 502 may be connected between the connections of switches 504a and 504c and switches 504b and 504d. Thus, by controlling the switching of the switches 504 (i.e., their on/off state), the direction of current flow across the capacitor 502 can be controlled.

The manner in which the switches 504 are controlled may be referred to as a modulation scheme, e.g., according to a demand on/from the AC power grid 402. The switches 504 of each submodule 404 may be controlled using a same modulation scheme or different modulation schemes, for example with a predetermined delay (or phase difference) between the modulation scheme of different submodules 404.

An example of a modulation scheme may be a phase shifted carrier (PSC) modulation with pulse-width modulation (PWM). The particulars of converter modulation are outside of the scope of the present disclosure. However, a PSC-PWM modulation is an example of a modulation scheme that conforms to an assumption of even power losses across the components of different submodules 404 having a same position in the circuit topology 500.

In the method 1000, the ON-state current $i_{ON}(t)$, through the semiconductor switch 100, 504, may be obtained by direct measurement. Alternatively, the ON-state current $i_{ON}(t)$, may be estimated based on a measured current through a submodule 404 in which the semiconductor switch 100 is arranged, such as the arm current $i_{arm}$.

Further, the above method 1000 may be applied to a group of semiconductor switches in arranged in a same position in the circuit topology of their respective submodule. For example, the method may be used to estimate the ON-state resistance of each of the top left semiconductor switches 504a in a plurality of series-connected submodules 404. The method 1000 may further comprise determining a group value of the estimated resistance, such as a mean or a median of the estimated resistances. The method 1000 may further comprise determining a deviation of the estimated resistance from the group value for at least one semiconductor switch 504a in the group. As the semiconductor switches 504a are initially substantially identical, and subject to the same current and a similar switching behavior, the resistance should theoretically change in the same way over time. Any deviation from the group value could then be attributed to a deterioration of the semiconductor switch in question. The method 1000 may further comprise determining a state of health for the semiconductor switch having a deviating value based on the determined deviation.

Returning to the general mathematical description provided above, and using the notation of Figures 1-3, during the ON-state of the device 100, the voltage $v_{ON}(t)$ of the device 100 may be described as

$$v_{ON}(t) = R_{ON}(t)i_{ON}(t)$$

$$(13)$$

$i_{ON}(t)$ is the current passing through the device 100 as shown in Fig.1. For an arbitrary device in a full-bridge, the current $i_{ON}(t)$ can be defined as,

$$i_{ON}(t) = i_{arm} \times s(t) = \hat{\imath} \sin(\omega t + \varphi_i) \times s(t)$$

$$(14)$$

Where the s(t) is the switching function. For a phase shifted carrier pulse width modulation scheme (PSC-PWM), s(t) can be mathematically described as

$$s(t) = 0.5 + m \sin(\omega t + \varphi_s) + h_s(t)$$

$$(15)$$

Where m is the modulation index and $h_s(t)$ is the sum of all harmonic content. The switching function is a series of 0 and 1 signals. 1 representing a turn-ON and 0 representing a turn-OFF. Regardless of what modulation scheme is used, s(t) will have the dc component 0.5, a fundamental frequency component, and other harmonics $h_s(t)$. $h_s(t)$ includes integer multiple harmonics and interharmonics. Regardless of the modulation scheme, the 0.5 dc value will always be there because the sum of the upper and lower switch functions in a half bridge is 1 p.u.

In case the deadtime between the upper and lower switch is significantly large, the dc value in $s(t)$ will not be 0.5. In that case, it may be better to measure the actual value from the switching pattern online rather than assuming the 0.5. In either case, the general proposed technique is still valid. Also, given the very short time of the deadtime compared to the actual on and off states, the error of assuming 0.5 may be far below 1%.

Substituting $i_{ON}(t)$ in equation (13) with (14) and (15) yields

$$v_{ON}(t) = R_{ON}\hat{\imath} \sin(\omega t + \varphi_i) \times (0.5 + m \sin(\omega t + \varphi_s) + h_s(t)) =$$

$$\frac{R_{ON}}{2}\hat{\imath} \sin(\omega t + \varphi_i) + \left(\frac{R_{ON} m \hat{\imath}}{2}(\cos(\varphi_i - \varphi_s) - \cos(2\omega t + \varphi_i + \varphi_s))\right)$$

$$+ R_{ON}\hat{\imath} \sin(\omega t + \varphi_i)\, h_s(t)$$

$$(16)$$

The only term that ends up with fundamental frequency is $\frac{R_{ON}}{2}\hat{\imath} \sin(\omega t + \varphi_i)$. This is the term of interest. $v_{ON}(t)$ and $i_{ON}(t)$ represent $x(t)$ and $y(t)$ in equation (3) above. Hence, the parameter R can be estimated by extracting $\frac{R_{ON}}{2}\hat{\imath}$ from equation (16) and $\hat{\imath}$ from the arm current $i_{arm}$. often mostly comprised of a fundamental component, while $v_{ON}$ may require longer integration to reduce the effect of noise and harmonics.

For estimating the $R_{ON}$ value, a selected frequency component, such as the fundamental frequency component, or the DC component can be analysed. For the DC component, it is sufficient integrate the $v_{ON}$ and $i_{ON}$ as follows

$$\int |v_{ON}(t)| dt = \int |R_{ON} i_{ON}(t)| dt$$

or

$$R_{ON} = \frac{\int |v_{ON}(t)| dt}{\int |i_{ON}(t)| dt}$$

$$(17)$$

With reference to Figures 5 to 7, a method for estimating a circuit parameter of a supercapacitor in an energy storage system, in accordance with some embodiments, will be described.

Figure 6 schematically shows a single supercapacitor cell 600 equipped with a balancing circuit comprising a switch 606 and a balancing resistor 604. The voltage balancing circuit 604, 606 may provide equal voltage sharing between series-connected supercapacitor cells in steady state.

In Figure 6, the supercapacitor cell is modeled by a supercapacitor 602, an equivalent series resistance 608 a leakage resistance 610. The current source represents the controlled current $i_{inj}$ injected into the supercapacitor cell 600.

Figure 5 is a flowchart illustrating a method 2000 for estimating a circuit parameter of a supercapacitor in an energy storage system. The method 2000 may for example be used to estimate the capacitance 602, the leakage resistance 610 or the ESR 608 of the supercapacitor 600 illustrated in Figure 5.

The method 2000 comprises injecting, at step 2010, a current $i_{inj}(t)$ in the supercapacitor 600. At step 2020, a voltage $v_c(t)$ measured across the supercapacitor is obtained from a measurement circuit (not depicted).

The method 2000 further comprises the optional steps 2030 and 2040. In embodiments including the optional steps 2030 and 2040, the injected current $i_{inj}(t)$ has a selected frequency $\omega$.

At the optional step 2030, voltage harmonics of the selected frequency $\omega$ are extracted from the voltage $v_c(t)$. At the optional step 2040, current harmonics of the selected frequency $\omega$ are extracted from the injected current $i_{inj}(t)$. The current harmonics may be extracted from the injected current reference or from a measurement of the actual injected current.

Steps 2050 and 2060 are integration steps.

If the optional steps 2030 and 2040 are not present, the voltage $v_c(t)$ is integrated over a period of time T at step 2050, and the injected current $i_{inj}(t)$ is integrated over the period of time T at step 2060.

If the optional steps 2030 and 2040 are present, the extracted voltage harmonics are integrated over a period of time T at step 2050 and the extracted current harmonics are integrated over the period of time T at step 2060.

At step 2070, the circuit parameter 602, 608, 610 is estimated based on the results of the integrations from steps 2050 and 2060.

At step 2070, an obtained offset of the voltage measurement $v_c(t)$ and/or the current measurement $i_{inj}(t)$ may be removed prior to the estimation of the circuit parameter.

The estimated circuit parameter(s) may be used, in an optional further step (not depicted), to estimate a state of health of the supercapacitor 600.

Figure 7 schematically shows a plurality of series-connected supercapacitor cells $600_1$, $600_2$, $600_N$. In an ESS, several supercapacitors are series-connected in order to achieve higher voltage capability.

The method 2000 described above may be applied to each of the supercapacitors $600_1$, $600_2$, $600_N$, to estimate a circuit parameter of each of the supercapacitors $600_1$, $600_2$, $600_N$, such as the capacitances $602_1$, $602_2$, $602_N$, the ESRs $608_1$, $608_2$, $608_N$, or the leakage resistances $610_1$, $610_2$, $610_N$.

The method 2000 may further comprise determining a group value of the circuit parameter estimate, such as a mean or a median of the circuit parameter estimates of each of the supercapacitors $600_1$, $600_2$, $600_N$.

The method 2000 may further comprise determining or detecting a deviation of the circuit parameter estimate from the group value for at least one of the of the supercapacitors $600_1$, $600_2$, $600_N$. As the of the supercapacitors $600_1$, $600_2$, $600_N$ are initially substantially identical, and subject to the same current, the circuit parameters should theoretically change in the same way over time. Any deviation from the group value could then be attributed to a deterioration of the supercapacitor in question. The method 2000 may further comprise determining a state of health for the supercapacitor having a deviating value based on the determined deviation.

The person skilled in the art realizes that the present invention by no means is limited to the preferred embodiments described above. On the contrary, many modifications and variations are possible within the scope of the appended claims.

In the claims, the word "comprising" does not exclude other elements, and the indefinite article "a" or "an" does not exclude a plurality.

**Claims**

1. A computer-implemented method (1000) for estimating an ON-state resistance of a semiconductor switch (100) in an electric power converter, the method comprising:

    obtaining (1010), from a measurement circuit, an ON-state voltage ($v_{ON}(t)$) of the semiconductor switch;
    obtaining (1020) an ON-state current ($i_{ON}(t)$) through the semiconductor switch;
    obtaining a selected frequency ($\omega$);
    extracting (1030) voltage harmonics of the selected frequency from the ON-state voltage;
    extracting (1040) current harmonics of the selected frequency from the ON-state current;
    integrating (1050) the voltage harmonics over a period of time (T), to obtain an integrated voltage;
    integrating (1060) the current harmonics over the same period of time (T), to obtain an integrated current;
    determining (1070) an ON-state resistance estimate of the semiconductor switch based on the integrated voltage and the integrated current.

2. The method of claim 1, wherein:

    said extracting (1030) voltage harmonics of the selected frequency comprises multiplying the ON-state voltage with a vector rotating at the selected frequency; and
    said extracting (1040) current harmonics of the selected frequency comprises multiplying the ON-state current with a vector rotating at the selected frequency.

3.  A computer-implemented method for determining a state of health of a semiconductor switch (100) in an electric power converter, the method comprising:

    determining an ON-state resistance estimate of the semiconductor switch in accordance with any of the preceding claims; and
    determining a state of health of the semiconductor switch based on the determined ON-state resistance estimate.

4.  The method of any of the preceding claims, wherein:

    said converter comprises a plurality of series-connected submodules (404), each comprising a capacitor (502) and a plurality of semiconductor switches (504a-d) arranged in a half-bridge or a full-bridge submodule topology; and
    said semiconductor switch (504a-d) is one of the plurality of semiconductor switches of one of the series-connected submodules.

5.  The method of claim 4 when dependent on claim 3, wherein said semiconductor switch (504a) is one of a group of semiconductor switches arranged in a same position in the circuit topology of their respective submodule (404), wherein:

    the determining an ON-state resistance estimate comprises determining an ON-state resistance estimate for each of the group of semiconductor switches; and
    the determining a state of health comprises:

        determining, for the group of semiconductor switches, a group value of the estimated resistance;
        determining a deviation of the estimated resistance from the group value, for at least one semiconductor switch in the group; and
        determining a state of health for said at least one semiconductor switch of the group based on the determined deviation for the semiconductor switch.

6.  A computer-implemented method (2000) for estimating a circuit parameter of a supercapacitor (600) in an energy storage system, the method comprising:

    injecting (2010) a current ($i_{inj}(t)$) having a selected frequency ($\omega$) in the supercapacitor;
    obtaining (2020), from a measurement circuit, a voltage ($v_c(t)$) measured across the supercapacitor;
    extracting (2030) voltage harmonics of the selected frequency from the voltage; and
    extracting (2040) current harmonics of the selected frequency from the injected current;
    integrating (2050) the voltage harmonics over a period of time (T), to obtain an integrated voltage;
    integrating (2060) the current harmonics over the same period of time (T), to obtain an integrated current;
    determining (2070) a circuit parameter (602, 608, 610) estimate of the supercapacitor based on the integrated voltage and the integrated current.

7.  The method of claim 6, wherein:

    said extracting (2030) voltage harmonics of the selected frequency comprises multiplying the voltage with a vector rotating at the selected frequency; and
    said extracting (2040) current harmonics of the selected frequency comprises multiplying the injected current with a vector rotating at the selected frequency.

8.  The method of any of claims 6 or 7, further comprising:

    obtaining current measurements of a current running through the supercapacitor;
    wherein said current harmonics are extracted from the current measurements.

9.  A computer-implemented method for determining a state of health of a supercapacitor (600) in an energy storage system, the method comprising:

determining a circuit parameter estimate of the supercapacitor in accordance with any of claims 6-8; and
determining a state of health of the supercapacitor based on the determined circuit parameter estimate.

10. The method of any of claims 6-9, wherein said supercapacitor is one of a group of supercapacitors ($600_1$, $600_2$, $600_N$) arranged in series.

11. The method of claim 10, when dependent on claim 9, wherein:

the determining a circuit parameter estimate comprises determining a circuit parameter estimate for each of the group of supercapacitors ($600_1$, $600_2$, $600_N$) arranged in series; and
the determining a state of health comprises:

determining, for the group of supercapacitors a group value of the circuit parameter estimate;
determining a deviation of the circuit parameter estimate from the group value, for at least one supercapacitor in the group; and
determining a state of health for said at least one supercapacitor of the group based on the determined deviation for the supercapacitor.

12. The method of any of claims 6-11, wherein said supercapacitor (600) is arranged as a DC link of a converter.

13. A control unit comprising means for carrying out the method according to any of claims 1-5.

14. A control unit comprising means for carrying out the method according to any of claims 6-12.

15. A computer-readable medium comprising instructions which, when executed by a computer, cause the computer to carry out the method according to any of claims 1-12.


**Patentansprüche**

1. Computerimplementiertes Verfahren (1000) zum Schätzen eines EIN-Zustand-Widerstands eines Halbleiterschalters (100) in einem elektrischen Leistungsumrichter, wobei das Verfahren Folgendes umfasst:

Erhalten (1010), von einer Messschaltung, einer EIN-Zustand-Spannung ($v_{ON}(t)$) des Halbleiterschalters;
Erhalten (1020) eines EIN-Zustand-Stroms ($i_{ON}(t)$) durch den Halbleiterschalter;
Erhalten einer ausgewählten Frequenz ($\omega$);
Extrahieren (1030) von Spannungsoberschwingungen der ausgewählten Frequenz aus der EIN-Zustand-Spannung;
Extrahieren (1040) von Stromoberschwingungen der ausgewählten Frequenz aus dem EIN-Zustand-Strom;
Integrieren (1050) der Spannungsoberschwingungen über einen Zeitraum (T), um eine integrierte Spannung zu erhalten;
Integrieren (1060) der Stromoberschwingungen über denselben Zeitraum (T), um einen integrierten Strom zu erhalten;
Bestimmen (1070) einer Schätzung des EIN-Zustand-Widerstands des Halbleiterschalters basierend auf der integrierten Spannung und dem integrierten Strom.

2. Verfahren nach Anspruch 1, wobei:

das Extrahieren (1030) von Spannungsoberschwingungen der ausgewählten Frequenz Multiplizieren der EIN-Zustand-Spannung mit einem mit der ausgewählten Frequenz rotierenden Vektor umfasst; und
das Extrahieren (1040) von Stromoberschwingungen der ausgewählten Frequenz Multiplizieren des EIN-Zustand-Stroms mit einem mit der ausgewählten Frequenz rotierenden Vektor umfasst.

3. Computerimplementiertes Verfahren zum Bestimmen eines Gesundheitszustands eines Halbleiterschalters (100) in einem elektrischen Leistungsumrichter, wobei das Verfahren Folgendes umfasst:

Bestimmen einer Schätzung des EIN-Zustand-Widerstands des Halbleiterschalters gemäß einem der vorhergehenden Ansprüche; und

Bestimmen eines Gesundheitszustands des Halbleiterschalters basierend auf der bestimmten Schätzung des EIN-Zustand-Widerstands.

4.  Verfahren nach einem der vorhergehenden Ansprüche, wobei:

    der Umrichter mehrere in Reihe geschaltete Submodule (404) umfasst, die jeweils einen Kondensator (502) und mehrere Halbleiterschalter (504a-d) umfassen, die in einer Halbbrücken- oder einer Vollbrücken-Submodul-Topologie angeordnet sind; und
    der Halbleiterschalter (504a-d) einer der mehreren Halbleiterschalter eines der in Reihe geschalteten Submodule ist.

5.  Verfahren nach Anspruch 4 bei Abhängigkeit von Anspruch 3, wobei der Halbleiterschalter (504a) einer einer Gruppe von Halbleiterschaltern ist, die in einer gleichen Position in der Schaltungstopologie ihres jeweiligen Submoduls (404) angeordnet sind, wobei:

    das Bestimmen einer Schätzung des EIN-Zustand-Widerstands Bestimmen einer Schätzung des EIN-Zustand-Widerstands für jeden der Gruppe von Halbleiterschaltern umfasst; und
    das Bestimmen eines Gesundheitszustands Folgendes umfasst:

    Bestimmen, für die Gruppe von Halbleiterschaltern, eines Gruppenwerts des geschätzten Widerstands;
    Bestimmen einer Abweichung des geschätzten Widerstands von dem Gruppenwert für mindestens einen Halbleiterschalter in der Gruppe; und
    Bestimmen eines Gesundheitszustands für den mindestens einen Halbleiterschalter der Gruppe basierend auf der bestimmten Abweichung für den Halbleiterschalter.

6.  Computerimplementiertes Verfahren (2000) zum Schätzen eines Schaltungsparameters eines Superkondensators (600) in einem Energiespeichersystem, wobei das Verfahren Folgendes umfasst:

    Injizieren (2010) eines Stroms ($i_{inj}(t)$) mit einer ausgewählten Frequenz ($\omega$) in den Superkondensator;
    Erhalten (2020), von einer Messschaltung, einer Spannung ($v_c(t)$), die über den Superkondensator gemessen wird;
    Extrahieren (2030) von Spannungsoberschwingungen der ausgewählten Frequenz aus der Spannung; und
    Extrahieren (2040) von Stromoberschwingungen der ausgewählten Frequenz aus dem injizierten Strom;
    Integrieren (2050) der Spannungsoberschwingungen über einen Zeitraum (T), um eine integrierte Spannung zu erhalten;
    Integrieren (2060) der Stromoberschwingungen über denselben Zeitraum (T), um einen integrierten Strom zu erhalten;
    Bestimmen (2070) einer Schätzung eines Schaltungsparameters (602, 608, 610) des Superkondensators basierend auf der integrierten Spannung und dem integrierten Strom.

7.  Verfahren nach Anspruch 6, wobei:

    das Extrahieren (2030) von Spannungsoberschwingungen der ausgewählten Frequenz Multiplizieren der Spannung mit einem mit der ausgewählten Frequenz rotierenden Vektor umfasst; und
    das Extrahieren (2040) von Stromoberschwingungen der ausgewählten Frequenz Multiplizieren des injizierten Stroms mit einem mit der ausgewählten Frequenz rotierenden Vektor umfasst.

8.  Verfahren nach einem der Ansprüche 6 oder 7, das ferner Folgendes umfasst:

    Erhalten von Strommessungen eines Stroms, der durch den Superkondensator fließt;
    wobei die Stromoberschwingungen aus den Strommessungen extrahiert werden.

9.  Computerimplementiertes Verfahren zum Bestimmen eines Gesundheitszustands eines Superkondensators (600) in einem Energiespeichersystem, wobei das Verfahren Folgendes umfasst:

    Bestimmen einer Schaltungsparameterschätzung des Superkondensators gemäß einem der Ansprüche 6-8; und
    Bestimmen eines Gesundheitszustands des Superkondensators basierend auf der bestimmten Schaltungsparameterschätzung.

10. Verfahren nach einem der Ansprüche 6-9, wobei der Superkondensator einer aus einer Gruppe von in Reihe geschalteten Superkondensatoren ($600_1$, $600_2$, $600_N$) ist.

11. Verfahren nach Anspruch 10 bei Abhängigkeit von Anspruch 9, wobei:

das Bestimmen einer Schaltungsparameterschätzung Bestimmen einer Schaltungsparameterschätzung für jeden der Gruppe von in Reihe geschalteten Superkondensatoren ($600_1$, $600_2$, $600_N$) umfasst; und
das Bestimmen eines Gesundheitszustands Folgendes umfasst:

Bestimmen, für die Gruppe von Superkondensatoren, eines Gruppenwerts der Schaltungsparameterschätzung;
Bestimmen einer Abweichung der Schaltungsparameterschätzung von dem Gruppenwert für mindestens einen Superkondensator in der Gruppe; und
Bestimmen eines Gesundheitszustands für den mindestens einen Superkondensator der Gruppe basierend auf der bestimmten Abweichung für den Superkondensator.

12. Verfahren nach einem der Ansprüche 6-11, wobei der Superkondensator (600) als ein DC-Zwischenkreis eines Umrichters angeordnet ist.

13. Steuereinheit, die Mittel zum Durchführen des Verfahrens nach einem der Ansprüche 1-5 umfasst.

14. Steuereinheit, die Mittel zum Durchführen des Verfahrens nach einem der Ansprüche 6-12 umfasst.

15. Computerlesbares Medium, das Anweisungen enthält, die bei Ausführung durch einen Computer bewirken, dass der Computer das Verfahren nach einem der Ansprüche 1 bis 12 durchführt.

**Revendications**

1. Procédé (1000) mis en œuvre par ordinateur permettant d'estimer une résistance à l'état sous tension d'un commutateur à semi-conducteur (100) dans un convertisseur de puissance électrique, le procédé comprenant les étapes consistant à :

obtenir (1010), d'un circuit de mesure, une tension à l'état sous tension ($v_{ON}(t)$) du commutateur à semi-conducteur ;
obtenir (1020) un courant à l'état sous tension ($i_{ON}(t)$) à travers le commutateur à semi-conducteur ;
obtenir une fréquence sélectionnée ($\omega$) ;
extraire (1030) les harmoniques de tension de la fréquence sélectionnée à partir de la tension à l'état sous tension ;
extraire (1040) les harmoniques de courant de la fréquence sélectionnée à partir du courant à l'état sous tension ;
intégrer (1050) les harmoniques de tension sur une période de temps (T), pour obtenir une tension intégrée ;
intégrer (1060) les harmoniques de courant sur la même période de temps (T), pour obtenir un courant intégré ;
déterminer (1070) une estimation de résistance à l'état sous tension du commutateur à semi-conducteur en fonction de la tension intégrée et du courant intégré.

2. Procédé selon la revendication 1,

ladite extraction (1030) des harmoniques de tension de la fréquence sélectionnée comprenant l'étape consistant à multiplier la tension à l'état sous tension par un vecteur tournant à la fréquence sélectionnée ; et
ladite extraction (1040) des harmoniques de courant de la fréquence sélectionnée comprenant l'étape consistant à multiplier le courant à l'état sous tension par un vecteur tournant à la fréquence sélectionnée.

3. Procédé mis en œuvre par ordinateur pour déterminer un état de santé d'un commutateur à semi-conducteur (100) dans un convertisseur de puissance électrique, le procédé comprenant les étapes consistant à :

déterminer une estimation de résistance à l'état sous tension du commutateur à semi-conducteur selon l'une quelconque des revendications précédentes ; et
déterminer un état de santé du commutateur à semi-conducteur en fonction de l'estimation de la résistance à l'état sous tension déterminée.

4. Procédé selon l'une quelconque des revendications précédentes,

ledit convertisseur comprenant une pluralité de sous-modules (404) montés en série, chacun comprenant un condensateur (502) et une pluralité de commutateurs à semi-conducteur (504a-d) disposés selon une topologie en sous-module en pont complet ou en demi-pont ; et
ledit commutateur à semi-conducteur (504a-d) étant l'un parmi la pluralité de commutateurs à semi-conducteur de l'un des sous-modules connectés en série.

5. Procédé selon la revendication 4 lorsqu'elle dépend de la revendication 3, ledit commutateur à semi-conducteur (504a) étant un commutateur parmi un groupe de commutateurs à semi-conducteur situés dans une même position dans la topologie de circuit de leur sous-module (404) respectif,

la détermination d'une estimation de la résistance à l'état sous tension comprenant l'étape consistant à déterminer une estimation de la résistance à l'état sous tension pour chaque commutateur du groupe de commutateurs à semi-conducteur ; et
la détermination d'un état de santé comprenant les étapes consistant à :

déterminer, pour le groupe de commutateurs à semi-conducteur, une valeur de groupe de la résistance estimée,
déterminer un écart entre la résistance estimée et la valeur de groupe, pour au moins un commutateur à semi-conducteur dans le groupe ; et
déterminer un état de santé dudit au moins un commutateur à semi-conducteur du groupe en fonction de l'écart déterminé pour le commutateur à semi-conducteur.

6. Procédé (2000) mis en œuvre par ordinateur permettant d'estimer un paramètre de circuit d'un supercondensateur (600) dans un système de stockage d'énergie, le procédé comprenant les étapes consistant à :

injecter (2010) un courant ($i_{inj}(t)$) ayant une fréquence choisie ($\omega$) dans le supercondensateur ;
obtenir (2020), à partir d'un circuit de mesure, une tension mesurée ($v_c(t)$) dans le supercondensateur ;
extraire (2030) les harmoniques de tension de la fréquence sélectionnée à partir de la tension ; et
extraire (2040) les harmoniques de courant de la fréquence sélectionnée à partir du courant injecté ;
intégrer (2050) les harmoniques de tension sur une période de temps (T), pour obtenir une tension intégrée ;
intégrer (2060) les harmoniques de courant sur la même période de temps (T), pour obtenir un courant intégré ;
déterminer (2070) une estimation de paramètre de circuit (602, 608, 610) du supercondensateur en fonction de la tension intégrée et du courant intégré.

7. Procédé selon la revendication 6,

ladite extraction (2030) des harmoniques de tension de la fréquence sélectionnée comprenant l'étape consistant à multiplier la tension par un vecteur tournant à la fréquence sélectionnée ; et
ladite extraction (2040) des harmoniques de courant de la fréquence sélectionnée comprenant l'étape consistant à multiplier le courant injecté par un vecteur tournant à la fréquence sélectionnée.

8. Procédé selon l'une quelconque des revendications 6 et 7, comprenant en outre l'étape consistant à :

obtenir des mesures de courant d'un courant traversant le supercondensateur ;
lesdites harmoniques de courant étant extraites des mesures de courant.

9. Procédé mis en œuvre par ordinateur pour déterminer un état de santé d'un supercondensateur (600) dans un système de stockage d'énergie, le procédé comprenant les étapes consistant à :

déterminer une estimation de paramètre de circuit du supercondensateur selon l'une quelconque des revendications 6 à 8 ; et
déterminer un état de santé du supercondensateur en fonction de l'estimation de paramètre de circuit déterminée.

10. Procédé selon l'une quelconque des revendications 6 à 9, ledit supercondensateur étant l'un d'un groupe de supercondensateurs ($600_1$, $600_2$, $600_N$) disposés en série.

11. Procédé selon la revendication 10, lorsqu'elle dépend de la revendication 9,

la détermination d'une estimation de paramètre de circuit comprenant l'étape consistant à déterminer une estimation de paramètre de circuit pour chacun des groupes de supercondensateurs ($600_1$, $600_2$, $600_N$) disposés en série ; et
la détermination d'un état de santé comprenant les étapes consistant à :

déterminer, pour le groupe de supercondensateurs, une valeur de groupe de l'estimation de paramètre de circuit ;
déterminer un écart entre l'estimation de paramètre de circuit et la valeur de groupe, pour au moins un supercondensateur du groupe ; et
déterminer un état de santé pour ledit au moins un supercondensateur du groupe en fonction de l'écart déterminé pour le supercondensateur.

12. Procédé selon l'une quelconque des revendications 6 à 11, ledit supercondensateur (600) étant conçu sous la forme d'une liaison à courant continu d'un convertisseur.

13. Unité de commande comprenant un moyen pour mettre en œuvre le procédé selon l'une quelconque des revendications 1 à 5.

14. Unité de commande comprenant un moyen pour mettre en œuvre le procédé selon l'une quelconque des revendications 6 à 12.

15. Support lisible par ordinateur comprenant des instructions qui, lorsqu'elles sont exécutées par un ordinateur, amènent l'ordinateur à mettre en œuvre le procédé selon l'une quelconque des revendications 1 à 12.

*Fig. 1*

*Fig. 2*

*Fig. 3*

_1000_

| 1010 |
| 1020 |
| 1030 |
| 1040 |
| 1050 |
| 1060 |
| 1070 |

_Fig. 4_

_2000_

| 2010 |
| 2020 |
| 2030 |
| 2040 |
| 2050 |
| 2060 |
| 2070 |

_Fig. 5_

_600_

_604_   _606_

_608_

_602_

_610_

$v_c(t)$

_612_

_Fig. 6_

$i_{inj}(t)$

_600₁_   _600₂_   _600_N

$608_1$   $608_2$   $608_N$

$602_1$   $602_2$   $602_N$

$610_1$   $610_2$   $610_N$

$v_{c1}(t)$   $v_{c2}(t)$   $v_{cN}(t)$

_Fig. 7_

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017254842 A1

- WO 2017071754 A1